# EUROPÄISCHE PATENTSCHRIFT

(11) **EP 2 024 141 B1**
(45) Veröffentlichungstag und Bekanntmachung des Hinweises auf die Patenterteilung: **07.10.2009**
(21) Anmeldenummer: 07723161.1
(22) Anmeldetag: 09.03.2007
(51) Int. Cl.: B25J 7/00, B81B 3/00

(54) **HERSTELLUNG EINES MIKROGREIFERS MITTELS EINES MATERIALABSCHEIDEVERFAHRENS**
PRODUCTION OF A MICROGRIPPER BY MEANS OF A MATERIAL DEPOSITION METHOD
FABRICATION D'UNE MICROPINCE AU MOYEN D'UN PROCÉDÉ DE SÉPARATION DE MATÉRIAUX

(30) Priorität: 20.05.2006 DE 102006023768
(43) Veröffentlichungstag der Anmeldung: 18.02.2009
(73) Patentinhaber: Fraunhofer-Gesellschaft zur Förderung der Angewandten Forschung e.V., 80686 München (DE); Carl Zeiss NTS GmbH, 73447 Oberkochen (DE)
(72) Erfinder: GROSSE, Christian, 04808 Kollau (DE); ALTMANN, Frank, 06118 Halle (DE); SIMON, Michél, 06667 Reichardtswerben (DE); HOFFMEISTER, Hilmar, 48565 Steinfurt (DE); RIEMER, Detlef, 04416 Markkleeberg (DE)
(74) Vertreter: Rösler, Uwe
(86) Internationale Anmeldenummer: PCT/EP2007/002109
(87) Internationale Veröffentlichungsnummer: WO 2007/134660

(56) Entgegenhaltungen:
- DE-A1- 10 244 785
- DE-A1- 19 522 004
- CAESAR: "Annual Report 2003" [Online] 7. September 2004 (2004-09-07), , XP002444970 Gefunden im Internet: URL:http://web.archive.org/web/20040907012 914/http://www.caesar.de/uploads/media/AR_ 03_screen_finaleVersion.pdf> [gefunden am 2007-07-30] Absatz [2.1.13]

## Beschreibung

### Technisches Gebiet

Die Erfindung bezieht sich auf einen Mikrogreifer zum Aufnehmen und Halten von Mikrometer- oder Submikrometer-skaligen Objekten sowie auf ein Verfahren zur Herstellung desselben.

### Stand der Technik

Im Rahmen der Mikrosystemtechnik finden Mikrogreifer heute in zahlreichen Gebieten Verwendung. So werden Mikrogreifer bspw. in der Mikro- und Nanotechnik zur Manipulation und Montage oder zum Fügen von Kleinstobjekten eingesetzt. Weitere Anwendungsgebiete für Mikrogreifer finden sich in der Physik, der Biologie, der Chemie und der Medizin, wobei Mikrogreifer bspw. im Rahmen der Analyse und Untersuchung von Proben zum Aufnehmen, Greifen und Halten der Proben eingesetzt werden.

Die Mikrogreifer bestehen in der Regel aus einem Basiskörper, der mit zwei oder mehreren bewegbaren und/oder elastischen Greifelementen verbunden ist, die zum Aufnehmen und Halten eines Objektes dienen. Zur aktiven Betätigung der Greifelemente ist zumeist ein am Mikrogreifer vorhandener Aktor vorgesehen, der die gegeneinander wirkenden Greifelemente bewegt. Bei derartigen Mikrogreifern können teilweise die auf das Objekt einwirkenden Greifkräfte durch entsprechende Ansteuerung des Aktors eingestellt oder geregelt werden. Auch sind Mikrogreifer ohne Aktoren bekannt, bei denen das Aufnehmen und Halten eines Objektes nicht aktiv sondern passiv unter Ausnutzung elastischer Materialeigenschaften erfolgt. Mikrogreifer dieser Art weisen mindestens zwei gegenüberliegende, voneinander beabstandete Greifelemente auf, zwischen denen ein Objekt klemmbar ist. Durch das Einklemmen eines Objekts zwischen den Greifelementen werden diese elastisch verformt und erzeugen so die auf das Objekt rückwirkenden elastischen Haltekräfte.

Es sei an dieser Stelle darauf hingewiesen, dass sich für die folgenden Ausführungen der Begriff Mikrogreifer auf die Versionen mit nur zwei Greifelementen beschränkt.

So wird in der Druckschrift DE 195 23 229 A1 eine Ausführungsform eines Mikrogreifers für die Mikromontage offenbart, welcher aus einem Basiskörper, einem auf dem Basiskörper befestigten Piezotranslator als Linearaktor sowie einem mit dem Basiskörper und dem Piezotranslator verbundenen Mikrostrukturkörper besteht. In dem Mikrostrukturkörper sind zwei gegeneinander wirkende, sich gegenüberliegende Greifelemente sowie eine mechanische Hebelübersetzung mit Biegegelenken, zur vergrößernden Übertragung einer Linearbewegung des Piezotranslators auf die Greifelemente, konstruktiv in einem Bauteil vereint. Bei einer Längenänderung des Piezotranslators verformen sich die elastischen Biegeelemente und leiten so ein gezieltes Auseinander- oder Zueinanderbewegen der Greifelemente ein.

Die Herstellung des Mikrostrukturkörpers erfolgt aus einem beidseitig polierten (100)-Siliziumwafer mit einer Dicke von 240 µm mittels den bekannten Strukturierungsprozessen, Lithographie und anisotropes Ätzen. Anschließend wird der Mikrostrukturkörper auf dem Basiskörper, einem Siliziumsubstrat, mittels Kleber derart befestigt, dass nur ausgewählte kleine Berührungsflächen zwischen dem Mikrostrukturkörper und dem Basiskörper geklebt werden, wobei die Biegeelemente sowie die Greifelemente entlang der Berührungsflächen axial verschiebbar sind. Als wesentlicher Vorteil des beschriebenen Mikrogreifers wird die Herstellung des Mikrostrukturkörpers aus Silizium, speziell dessen gute Mikrostrukturierbarkeit sowie keine plastische Verformung von Silizium besonders hervorgehoben. Zudem besteht die Möglichkeit an den Greifelementen, insbesondere an deren jeweiligen Greifflächen piezoelektrische, bspw. piezoresistive, Schichten anzubringen, um die Greifkraft in ein elektrisches Signal umzuwandeln und dadurch die Greifkraft an das zu greifende Objekt anzupassen. Weitere Ausführungsformen von Mikrogreifern, die als Aktoren Piezosysteme verwenden, sind bspw. den Druckschriften DE 196 48 165 A1 sowie DE 101 14 551 C1 zu entnehmen.

Neben Piezosystemen werden zur Bewegung der Greifelemente auch andere Elemente oder Prinzipien verwendet. So ist der Druckschrift DE 197 15 083 A1 ein Mikrogreifer zu entnehmen, bei dem ebene Spulen oder Dauermagnete eines elektrodynamischen Antriebes in einen nachgiebigen Greifmechanismus integriert sind. Das Schließen der Greifelemente wird durch Anlegen eines äußeren Magnetfeldes bewirkt. Die Druckschriften US 2004/0004364 A1, US 2002 /0061662 A1 und US 5,149,673 A beschreiben hingegen Mikrogreifer, deren Greifelemente unter Nutzung elektrostatischer Anziehungs- oder Abstoßungskräfte bewegt werden können. Aus der Druckschrift US 2005/0029827 A1 geht schließlich ein Nanogreifer hervor, bei dem die Greifelemente unter Ausnutzung elektrothermischer Materialeigenschaften bewegt werden können. Dabei stehen die Greifelemente über einen Gelenkmechanismus mit Elementen in Verbindung, die sich infolge eines Stromdurchflusses erwärmen, dabei ausdehnen und über den Gelenkmechanismus eine Bewegung der Greifelemente hervorrufen.

Die bisher erwähnten Greifer haben alle den Nachteil, dass zum Greifen und Halten von Objekten die Zuführung elektrischer oder magnetischer Energie an den Aktor erforderlich ist. Wird diese unterbrochen oder gestört, so kommt es zu einem Versagen des Greifers, d.h. das Objekt kann sich ungewollt vom Mikrogreifer trennen. Außerdem ist die notwendige elektrische Adaptierung des Mikrogreifers in den erforderlichen Dimensionen im Mikrometerbereich aufwendig und kostenintensiv.

Für Anwendungen von Mikrogreifern im Rahmen der Materialanalyse von Mikrometer- oder Submikometer-skaligen Proben ist insbesondere jegliche Kontamination der Probe durch den Mikrogreifer, bspw. durch einen Materialübertrag von einer vorhergehenden Probe zur nächsten Probe, zu verhindern. Daher werden bspw. zum Greifen und Halten von Proben im Rahmen von Untersuchung insbesondere mit Elektronenmikroskopen, wie Transmissions-ElektronenMikroskopen (TEM) oder Scanning Electron Microscopes (SEM), für jede Probe neue Mikrogreifer verwendet. Da Mikrogreifer für derartige Zwecke nur zur einmaligen Nutzung bestimmt sind, sollten sie kostengünstig als Massenware produzierbar sein. Dennoch müssen sie alle Anforderungen erfüllen, um ein zuverlässiges Greifen und Halten bei solchen Anwendungen zu gewährleisten. Die vorstehend beschriebenen Mikrogreifer sind aus den genannten Gründen hierfür jedoch nicht oder nicht optimal geeignet.

Neben den vorstehend beschriebenen Mikrogreifern mit Aktoren wird in der Druckschrift US 2002/0166976 A1 ein Mikrogreifer beschrieben, der insbesondere auch für eine Verwendung zum Greifen und Halten einer Probe im Rahmen von Untersuchungen mit TEM geeignet ist. Der darin beschriebene Mikrogreifer besteht aus einem stab- oder zylinderförmigen länglichen Körper, der an einem Ende eine oder mehrere dreiseitig offene Aufnahmeschlitze derart aufweist, dass eine Probe in den Aufnahmeschlitz klemmbar ist. Das Aufnehmen und Halten der Probe basiert, wie vorstehend beschrieben, auf der elastischen Deformation des den Aufnahmeschlitz umgebenden Materials und der dadurch hervorgerufenen, auf die eingeklemmte Probe wirkenden Rückstellkraft.

Zur Herstellung des Mikrogreifers kann dem zitierten Dokument folgendes Verfahren entnommen werden. Als Ausgangsmaterial dient ein Stück geradliniger Wolframdraht mit einem Drahtdurchmesser von 50 µm. In einem ersten Verfahrensschritt wird ein Endbereich des Wolframdrahtes zunächst mittels Elektropolieren oder einem Ätzverfahren derart bearbeitet, dass sich der Wolframdraht in diesem Endbereich zum Drahtende hin bis auf einen Durchmesser von einigen Mikrometern verjüngt. In einem zweiten Arbeitsschritt wird aus dem sich nunmehr konisch verjüngenden Endbereich des Wolframdrahtes mittels eines senkrecht zur Längsachse des Wolframdrahtes auftreffenden lonenstrahls, ein zum Ende des verjüngten Bereichs hin dreiseitig offener Aufnahmeschlitz ausgearbeitet. In einem dritten Verfahrensschritt kann durch eine weitere Anwendung des lonenstrahls zusätzlich zu dem ersten Aufnahmeschlitz bspw. ein dazu um 90 Grad gedrehter zweiter Aufnahmeschlitz ausgearbeitet werden. Dadurch entstehen im verjüngten Endbereich des Wolframdrahtes mindestens zwei oder vier Greifelemente zwischen die ein Objekt klemmbar ist. Der Aufnahmeschlitz hat einem Ausführungsbeispiel zufolge eine Breite von 2 µm und eine Tiefe von 30 µm.

Nachteilig an dem in US 2002/0166976 A1 offenbarten Mikrogreifer ist, dass es durch das angegebene Herstellungsverfahren technisch nicht möglich ist, die den Aufnahmeschlitz begrenzenden Flächen, d.h. die innen liegenden Klemmflächen an den Greifelementen, exakt parallel zueinander herzustellen. Vielmehr wird durch die Anwendung des lonenstrahls zur Herstellung eines Aufnahmeschlitzes, der Aufnahmeschlitz an der dem Ionenstrahl zugewandten Seite breiter als auf der dem Ionenstrahl abgewandten Seite. Die somit erzeugten, den Schlitz begrenzenden Klemmflächen sind daher nicht parallel zueinander ausgerichtet. Dies führt letztlich zu einer ungleichmäßigen Verteilung von Klemmkräften auf das zu haltende Objekt und birgt die Gefahr, dass sich die zwischen die Klemmflächen geklemmten Objekte relativ zum Mikrogreifer verschieben können. Weiterhin eignet sich das beschriebene Verfahren nur bedingt , bzw. nicht zur Massenproduktion, da für jeden Mikrogreifer einzeln eine exakte Fixierung und Positionierung des Wolframdrahtes erforderlich ist, bevor die Bearbeitung mit dem Ionenstrahl erfolgen kann, was das Herstellungsverfahren langwierig und teuer macht.

Aus der DE 195 22 004 ist ein Herstellungsverfahren von teilbeweglichen Mikrostrukturen auf der Basis einer trockenchemisch geätzten Opferschicht zu entnehmen, wobei die zumeist aus Polyimid bestehende Opferschicht unmittelbar auf einer Substratschicht aufgebracht wird, auf der, vollständig durch die Opferschicht beabstandet zur Substratschicht, eine im weiteren teilbewegliche mikrostrukturierte Materialschicht, bspw. in weiterer Ausbildung als Cantilever mit oder ohne zusätzlicher Spitze aufgebracht wird. Zu Zwecken der Teilbewegungsfähigkeit wird die zwischen der Cantileverschicht und dem Substrat befindliche Opferschicht lediglich teilweise im Wege eines trockenchemischen Ätzverfahrens entfernt, so dass ein Rest an Opferschicht als eine Art Abstandshalter bestehen bleibt.

Dem Jahresbericht Caesar, "Annual Report 2003", 7. September 2004, XP002444970 kann ein Mikrogreifer entnommen werden, der zwei aus TiNi bestehende Greiferbacken vorsieht, die gemeinsam einen Aufnahmeschlitz beidseitig begrenzen. Zur Betätigung des Mikrogreifers ist auf der Oberfläche der oberen Greiferbacke eine Schicht aus Formgedächtnismetall (SMA) aufgebracht, ein Material, das sich durch entsprechende elektrische Stromversorgung in einer Art und Weise zu verformen vermag, wodurch die Greiferbacken von einer geschlossenen in eine geöffnete Stellung und umgekehrt überführbar sind. Aus den der Druckschrift entnehmbaren Greiferbackendarstellungen kann ersehen werden, dass die eine Greiferbacke einstückig mit dem aus Silizium bestehenden Substrat verbunden ist.

### Darstellung der Erfindung

Ausgehend vom beschriebenen Stand der Technik ist es Aufgabe der vorliegenden Erfindung ein Verfahren zur Herstellung eines Mikrogreifers sowie einen Mikrogreifer anzugeben, bei dem die vorstehend beschriebenen Nachteile vermieden werden. Der Mikrogreifer soll insbesondere als Massenware kostengünstig herstellbar sein, im Ruhezustand an den Greifelementen parallel zueinander ausgerichtete, sich gegenüberliegende Klemmflächen aufweisen und sich für das Aufnehmen, Transportieren und Halten von Materialproben im Rahmen von deren Untersuchung in einem TEM oder SEM eignen.

Die Lösung der der Erfindung zugrunde liegenden Aufgabe ist in Anspruch 1 sowie in Anspruch 8 angegeben. Dabei gibt der Anspruch 1 ein Verfahren zur Herstellung eines Mikrogreifers an, der einen Basiskörper sowie einen mit dem Basiskörper einstückig verbundenen Greifkörper umfasst, der den Basiskörper überragt und an einem freien Endbereich einen Aufnahmeschlitz derart vorsieht, dass zum Greifen und Halten ein Mikrometer- oder Submikrometer-skaliges Objekt in den Aufnahmeschlitz klemmbar ist. Das Verfahren zeichnet sich im Wesentlichen dadurch aus, dass der Basiskörper und der Greifkörper mittels eines Materialabscheideverfahrens unter Ausbildung wenigstens einer gemeinsamen ersten und einer gemeinsamen zweiten Materialschicht hergestellt werden, und dass die Materialschichten im wesentlichen eben ausgebildet und miteinander verbunden werden. Der Anspruch 8 gibt einen mit einem Vefahren nach Ansprch 1 hergestellten Mikrogreifer an, der sich in Wesentlichen dadurch auszeichnet, dass der Basiskörper und der Greifkörper als ein einheitlicher Flachkörper ausgebildet sind, der von zwei im wesentlichen ebenen, parallel zueinander orientierten und sich überlappenden Flachkörperoberflächen begrenzt ist.

Den Erfindungsgedanken vorteilhaft weiterbildende Merkmale sind Gegenstand der Unteransprüche sowie der Beschreibung, insbesondere unter Bezugnahme auf die Ausführungsbeispiele zu entnehmen.

Ein wesentlicher Gedanke der Erfindung liegt in der Herstellung eines Mikrogreifers gemäß dem Oberbegriff des Anspruchs 1, mittels eines Materialabscheideverfahrens unter Ausbildung zumindest zweier eben ausgebildeter und miteinander verbundener Materialschichten. Verfahren zur Abscheidung von Material sind dem Fachmann vielfältig bekannt. Für die erfindungsgemäße Herstellung eines Mikrogreifers eignen sich in besonderer Weise Verfahren aus der Dünnschichttechnologie, durch die Materialien in dünnen Schichten, mit Schichtdicken bis unter 1 µm, auf ein Substrat aufgebracht werden können. Für das Abscheiden der Schichten auf das Substrat kommen dabei insbesondere Physical Vapour Deposition-Verfahren (PVD), d.h. Aufdampfen oder Sputtern, Chemical Vapor Deposition-Verfahren (CVD) und davon abgeleitete Verfahren, wie Low Pressure CVD (LPCVD) oder Plasma Enhanced CVD (PECVD), oder galvanische Verfahren in Betracht. Die damit abgeschiedenen Schichten lassen sich durch Maskierungs- oder Lithografie-Verfahren mit anschließendem Materialabtrag durch Anwendung von naßchemischem Ätzen, reaktivem Ionenätzen (RIE), Sputterätzen, Ionenstrahlätzen oder Plasmaätzen nachträglich strukturieren. Alternativ zu der nachträglichen Strukturierung einer bereits aufgetragenen Schicht, kann die Strukturierung einer aufzutragenden Schicht auch durch eine gezielte lokale Materialabscheidung erreicht werden. Weiterhin kann durch Abscheiden einer so genannten Opferschicht zwischen zwei Materialschichten und der späteren Entfernung der Opferschichten, bspw. durch Nassätzverfahren, eine nahezu beliebige dreidimensionale Strukturierung der auf das Substrat aufgebrachten Materialschichten erreicht werden. Der Fachmann ist mit diesen Techniken und deren Anwendung vertraut.

Bei Verwendung eines im Rahmen der Dünnschichttechnologie beschriebenen oder bekannten Verfahrens zur erfindungsgemäßen Herstellung eines Mikrogreifers, besteht das Herstellungsverfahren für den Mikrogreifer in einem einfachen Fall aus folgenden Verfahrensschritten.

In einem ersten Verfahrensschritt wird eine ebene Substratoberfläche bereitgestellt. Hierfür eignet sich bevorzugt ein Siliziumsubstrat wegen dessen guter Oberflächenplanarität. In einem zweiten Verfahrensschritt wird auf die Substratoberfläche eine erste Opferschicht aufgebracht. Im dritten Verfahrensschritt wird die erste Materialschicht auf die erste Opferschicht aufgebracht. Im vierten Verfahrensschritt erfolgt das Aufbringen (und gegebenenfalls das Strukturieren) der zweiten Opferschicht auf die erste Materialschicht, zumindest auf einen lokalen Bereich der ersten Materialschicht. Üblicherweise wird der überwiegende Teil der ersten Materialschicht nicht von der zweiten Opferschicht bedeckt. Die zweite Opferschicht entspricht nach ihrem Auftrag auf den einen lokalen Bereich in ihren äußeren Abmessungen dem herzustellenden Aufnahmeschlitz am Greifkörper, so dass nach einem Entfernen der zweiten Opferschicht in diesem Bereich der Aufnahmeschlitz freigelegt wird. Im fünften Verfahrensschritt wird auf die zweite Opferschicht und die von der zweiten Opferschicht nicht bedeckten Bereiche der ersten Materialschicht, die zweite Materialschicht aufgebracht. Im einfachsten Fall sind die erste und die zweite Materialschicht mit Ausnahme des einen lokalen Bereichs direkt miteinander verbunden. Im sechsten Verfahrensschritt werden die erste und zweite Opferschicht entfernt. Das Entfernen der zweiten Opferschicht bildet den Aufnahmeschlitz aus, das Entfernen der ersten Opferschicht löst den nunmehr fertig hergestellten Mikrogreifer vom Substrat. Zum Entfernen der Opferschichten eignen sich insbesondere nasschemische Ätzverfahren.

Als Ergebnis der Verfahrensschritte 1 - 6 erhält man einen Mikrogreifer gemäß Anspruch 8 der sich im Wesentlichen dadurch auszeichnet, dass der Basiskörper und der Greifkörper des Mikrogreifers als ein einheitlicher Flachkörper ausgebildet sind, der von zwei im wesentlichen ebenen, parallel zueinander orientierten und sich überlappenden Flachkörperoberflächen, begrenzt ist. Dabei entsprechen die außen liegenden freien Oberflächen der ersten und zweiten Materialschichten den Flachkörperoberflächen.

Der Aufnahmeschlitz am Greifkörper weist innenliegend vorzugsweise zwei zueinander parallel angeordnete, voneinander beabstandete und sich überlappende Klemmflächen auf. Die Klemmflächen weisen dabei vorzugsweise einen Abstand von 10 nm bis 10 µm, insbesondere von 50 nm bis 1 µm voneinander auf.

Die laterale Dimensionierung der Flachkörperoberflächen, und damit die lateralen Formen des Basiskörpers, des Greifkörpers sowie letztlich auch der Klemmflächen im Aufnahmeschlitz, erfolgt durch eine entsprechende Strukturierung der im Rahmen des beschriebenen Materialabscheideverfahrens entstehenden Schichten. Wie vorstehend beschrieben, kann die gewünschte Strukturierung einer Schicht durch eine lokal, d.h. lateral entsprechend begrenzte Abscheidung der Schicht oder durch eine entsprechende laterale Strukturierung einer bereits abgeschiedenen Schicht erfolgen. Entsprechende Strukturierungsverfahren sind dem Fachmann bekannt. Durch eine solche Strukturierung der Schichten ist es insbesondere möglich, die laterale Dimensionierung des herzustellenden Mikrogreifers nahezu beliebig vorzugeben und so die Form des Basiskörpers, des Greifkörpers sowie der Klemmflächen den gewünschten Anforderungen anzupassen.

Durch eine entsprechende Strukturierung der Schichten während des Herstellungsverfahrens werden vorzugsweise Mikrogreifer hergestellt, deren Flachkörperoberflächen sich jeweils vollständig überlappen. Weiterhin werden mit dem erfindungsgemäßen Verfahren vorzugsweise Mikrogreifer hergestellt, die derart dimensioniert und ausgelegt sind, dass sie Proben, die bspw. mittels eines TEMs oder SEMs untersucht werden sollen, aufnehmen und halten können, und dass sie direkt in einen kommerziell verfügbare Probenhalterung eines TEM oder SEM eingelegt werden können. Für derartige TEM-/SEM-Anwendungen eignen sich insbesondere Mikrogreifer bei denen die Flachkörperoberflächen einem Kreissektor mit einem Mittelpunktswinkel α ≤ 180 Grad entsprechen und der Greifkörper an einer Kreissektorspitze den Kreissektor überragend angeordnet ist oder deren Flachkörperoberflächen einem Kreissegment mit einem Mittelpunktswinkel α ≤ 180 Grad entsprechen und der Greifkörper an der Kreissegmentsehne, insbesondere in der Mitte der Kreissegmentsehne, das Kreissegment überstehend angeordnet ist, und das Kreissegment oder der Kreissektor einen Kreisradius aufweist, der an einen Radius einer Probenhalterung eines Mikroskops, insbesondere eines SEM oder TEM, angepasst ist. Bei SEM oder TEM beträgt der Radius der Probenhalterung typischerweise 1,5 mm.

Darüber hinaus können die Flachkörperoberflächen einem Vieleck entsprechen, wobei der Greifkörper einen Umfangsrand des Vielecks überragend angeordnet ist, oder beliebige weitere Formen aufweisen.

Ebenso wird durch die Strukturierung der ersten und zweiten Materialschicht, die Form und relative Lage der Klemmflächen am Aufnahmeschlitz bestimmt. Vorzugsweise entsprechen die Klemmflächen einem Vieleck, insbesondere einem Rechteck oder Quadrat und überlappen sich jeweils vollständig. Für besondere Anwendungen eignen sich insbesondere auch Klemmflächen, die sich in Richtung der Öffnung des Aufnahmeschlitzes verjüngen. Je nach gewünschter Anwendung sind beliebige weitere Klemmflächenformen, durch eine entsprechende Strukturierung der ersten und zweiten Materialschicht, ebenfalls möglich.

Für das bisher beschriebene Herstellungsverfahren sollen nun einige weitere vorteilhafte Ausprägungen angegeben werden. So können für die Opferschichten folgende Materialien verwendet werden: Kunststoff, Metall oder insbesondere Siliziumoxid. Für die Materialschichten können folgende Materialien verwendet werden: Kunststoffe, Keramik, Metall, Halbmetall oder insbesondere Polysilizium. Die Verwendung der angegebenen Materialen für die Opferschichten oder die Materialschichten ist jedoch nicht beliebig. Dem Fachmann sind entsprechende Materialkombinationen, die sich für beschriebene Materialabscheide- und Opferschichttechnologie eigenen, bekannt. Als besonders geeignet hat sich die Paarung von Opferschichten aus Siliziumoxid und Materialschichten aus Polysilizium erwiesen.

Die erste und die zweite Materialschicht können aber auch aus unterschiedlichen Materialien bestehen und somit aufgrund der unterschiedlichen Materialeigenschaften der ersten und der zweiten Materialschicht dem erfindungsgemäßen Mikrogreifer besondere mechanische, elektrische, magnetische oder chemische Eigenschaften verleihen.

Weiterhin kann es aus verfahrenstechnischen Gründen vorteilhaft sein, vor dem Aufbringen der ersten Opferschicht auf der Substratoberfläche eine oder mehrere Zwischenschichten auf der Substratoberfläche aufzubringen. Zur Stabilisierung und zum Schutz besteht zudem die Möglichkeit auf die zweite Materialschicht eine oder mehrere Stabilisierungs- oder Schutzschichten aufzubringen.

Mit dem erfindungsgemäßen Verfahren ist insbesondere die gleichzeitige Herstellung einer Vielzahl von Mikrogreifern auf einem oder mehreren Flächensubstraten möglich. Dadurch lassen sich nicht nur Fertigungskosten reduzieren, sondern auch Lösungen realisieren, die bei einer hohen Fertigungsgenauigkeit eine nahezu beliebige und leicht zu ändernder Formgebung der flach ausgebildeten Mikrogreifer ermöglichen. Die erfindungsgemäßen Mikrogreifer eignen sich insbesondere für das Aufnehmen, Transportieren und Halten von Materialproben im Rahmen von deren Untersuchung in einem TEM oder SEM.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnungen exemplarisch beschrieben. Es zeigen:
- Fig. 1: Beispiel eines Mikrogreifers,
- Fig. 2a,b: Aufnehmen eines Objekts mit dem Mikrogreifer,
- Fig. 3a,b: Schichtaufbau eines Mikrogreifers,
- Fig. 4a-g: Verfahrensschritte zur Herstellung eines Mikrogreifers,
- Fig. 5: Herauslösen einer TEM-Probe aus einem Substrat (Stand der Technik),
- Fig. 6: Mikrogreifer mit TEM-Probe,
- Fig. 7a,b: Mikrogreifer mit kreissektorförmig gestaltetem Basiskörper und
- Fig. 8: Mikrogreifer mit halbkreisförmig gestaltetem Basiskörper.

### Wege zur Ausführung der Erfindung, gewerbliche Verwendbarkeit

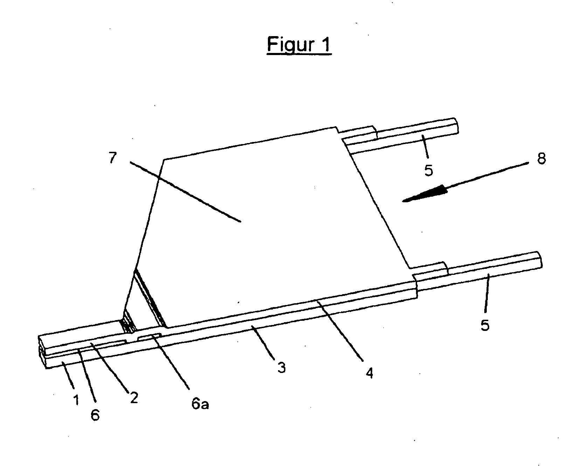

Figur 1 zeigt eine perspektivische Ansicht eines erfindungsgemäß hergestellten und als Flachkörper ausgebildeten Mikrogreifers 8. Der Flachkörper 8 besteht aus einer ersten Materialschicht 3 und einer zweiten, mit der ersten Materialschicht 3 verbundenen Materialschicht 4. Der Flachkörper 8 lässt sich in einen Basiskörper-Bereich mit dem zugehörigen Flachkörperoberflächenteil 7 sowie einen GreifkörperBereich mit den Greifelementen 1 und 2, zwischen denen sich der Aufnahmeschlitz 6 befindet, einteilen. Weiterhin ist bei dem abgebildeten Mikrogreifer 8 eine quer zu den Greifelementen 1, 2 verlaufende durchgehende Lücke 6a im Verbindungsbereich zwischen Basiskörper und Greifkörper vorgesehen. Diese dient einer verbesserten Einleitung von Kräften, die durch eine elastische Verformung der Greifelemente 1, 2 entstehen, in die Materialschichten 3 und 4. An der rechten Seite der abgebildeten Mikrogreifers 8 sind dünne Stege 5 zur Befestigung des Mikrogreifers auf dem Substrat 9 vorgesehen. Der Hintergrund hierfür ist, dass während des Ätzprozesses, bei dem die Opferschichten entfernt werden, die Gefahr besteht, dass sich der Mikrogreifer 8 unkontrolliert vom Substrat 9 lösen kann und verloren gehen kann. Dies wird durch die dünnen Stege 5 verhindert, über die der Mikrogreifer nach dem Ätzen der Opferschichten noch mit dem Substrat verbunden bleibt, wie nachfolgend noch näher erläutert wird.

Die Flachkörperoberfläche 7 dient als Adapterfläche, bspw. zum Aufnehmen des Mikrogreifers in ein Handhabungssystem (Transportmanipulator), oder zum Einlegen in die Aufnahmeeinheit eines Analysegerätes (SEM, TEM). Im vorliegenden Fall hat sie die Form eines Vielecks. Die Flachkörperoberfläche kann dabei jedoch im Rahmen des Herstellungsverfahrens entsprechend den gegebenen Anforderungen optimal dimensioniert werden.

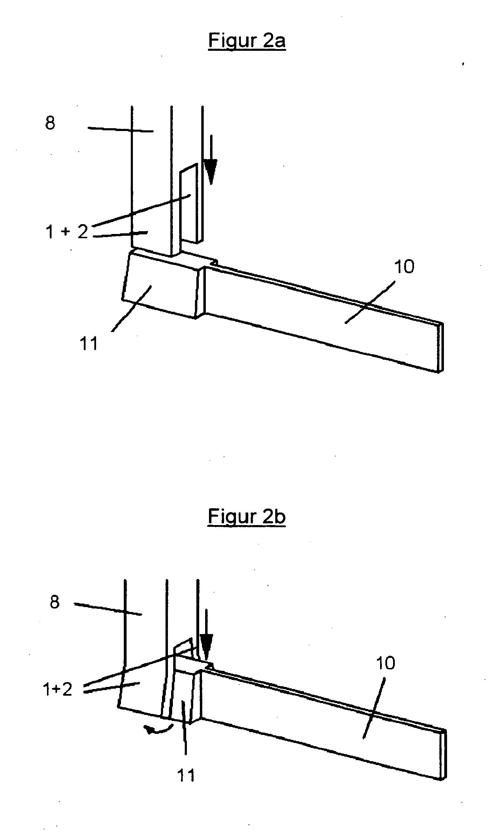

Die Figuren 2a und 2b zeigen die Funktionsweise des Mikrogreifers 8. Dargestellt sind der Greifkörperbereich des Mikrogreifers 8 mit den Greifelementen 1, 2 und dem zwischen den Greifelementen 1, 2 liegenden Aufnahmeschlitz 6, sowie eine Materialprobe 10, an der eine Schräge 11 vorgesehen ist. Zum Aufnehmen der Materialprobe 10 mit dem Mikrogreifer 8, wird gemäß Figur 2a der Mikrogreifer 8 mit den Greifelementen 1,2 von oben an die Schräge 11 der Materialprobe 10 herangeführt. Die Schräge 11 dient einem optimalen Kraftschluss zwischen den Greifelementen 1, 2 und der Materialprobe 10. Grundsätzlich ist eine solche Schräge jedoch nicht erforderlich. Figur 2b zeigt, dass die Greifelemente 1, 2 über die Schräge 11 der Materialprobe geschoben und dadurch gespreizt werden. Durch die Spreizung wird eine elastische Verformung der Greifelement 1, 2 hervorgerufen, die rückwirkend auf die Schräge eine Haltekraft erzeugt. Aufgrund dieser Haltekraft und der zwischen den Klemmflächen der Greifelemente 1, 2 und der Schräge 11 wirkenden Reibungskräfte wird ein Halten der Materialprobe erreicht.

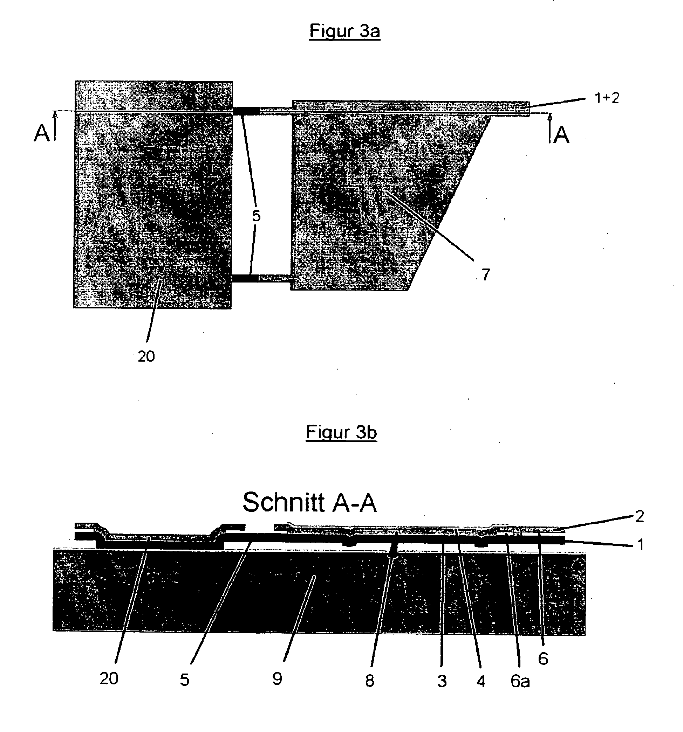

In den Figuren 3a und 3b wird der Mikrogreifer aus Figur 1 in der Herstellungsphase gezeigt, nachdem die Opferschichten entfernt wurden. Figur 3a zeigt zunächst eine Aufsicht auf den Mikrogreifer 8. Der Mikrogreifer 8 ist dabei über die Stege 5 mit einem Haltebereich 20 verbunden. Da der Haltebereich 20 auch nach dem Entfernen der Opferschichten fest mit dem Substrat 9 (nicht dargestellt) verbunden ist, wird der vom Substrat 9 vollständig gelöste Mikrogreifer 8 noch über die Stege 5 vom Haltebereich 20 gehalten. Ein unbeabsichtigtes Lösen oder Verlorengehen des Mikrogreifers 8 nach dem Entfernen der Opferschichten kann somit verhindert werden. Zum Herauslösen des Mikrogreifer sind lediglich die Stege 5 zu durchtrennen. Die Anzahl, die Anordnung und der Querschnitt (Breite und Höhe) der Stege 5 richtet sich im Wesentlichen nach der Haltekraft, die von den Stegen aufgenommen werden soll. Die Figur 3b zeigt einen Schnitt durch den Schichtenaufbau entlang der Schnittlinie A-A'. Deutlich zu erkennen ist, dass das Substrat 9 auch nach dem Entfernen der Opferschichten noch fest mit dem Haltebereich 20 verbunden ist. Der Mikrogreifer 8 besteht aus der ersten Materialschicht 3 und der zweiten Materialschicht 4, die miteinander verbunden sind.

Die entfernten Opferschichten haben den Aufnahmeschlitz 6 und die Lücke 6a freigelegt. Der Mikrogreifer 8 ist über die Stege 5, die aus der ersten Materialschicht gebildet sind, mit dem Haltebereich 20 verbunden.

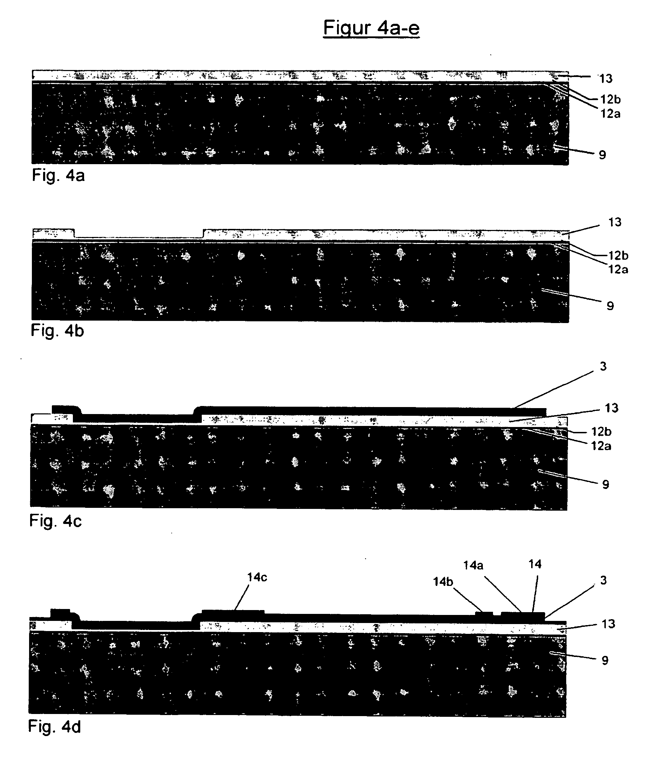

Die Figuren 4a - 4g erläutern das Verfahren zur Herstellung des in den Figuren 3a und 3b gezeigten Mikrogreifers anhand des schrittweisen Schichtaufbaus in einer Querschnittsdarstellung entlang der Schnittlinie A-A' von Figur 3a.
- Figur 4a: In einem ersten Verfahrensschritt wird auf ein ebenes Substrat 9 aus Silizium eine Zwischenschicht 12a und 12b aufgebracht. Diese Zwischenschicht 12a besteht aus Siliziumnitrid und dient als elektrischer Isolator, die Zwischenschicht 12b besteht aus Polysilizium und dient als Startschicht. Auf diese Zwischenschicht 12 wird nun eine erste Opferschicht 13 aus Siliziumoxid abgeschieden. Die erste Opferschicht 13 wird anschließend maskiert. Dies erfolgt durch Aufbringen einer Photoresist-Schicht oder einer ähnliche Maskierung. Das Herausarbeiten der Maskierungsform kann bspw. durch Belichten mit einem Elektronenstrahl oder mit UV-Licht erfolgen.
- Figur 4b: Nachdem die Maskierung fertig gestellt wurde, wird die erste Opferschicht 13 an den freiliegenden Stellen mittels reaktivem Ionenätzen (RIE) entfernt. Figur 4b zeigt, dass die Opferschicht 13 zumindest in dem Bereich entfernt wird, auf dem der spätere Haltebereich 20 hergestellt werden soll.
- Figur 4c: Auf die erste Opferschicht 13 wird nachfolgend die erste Materialschicht 3 aus Polysilizium abgeschieden. Die erste Materialschicht 3 wird ebenfalls, wie oben beschrieben, mit einer Maskierung in der gewünschten Form versehen und zum Beispiel durch RIE geätzt.

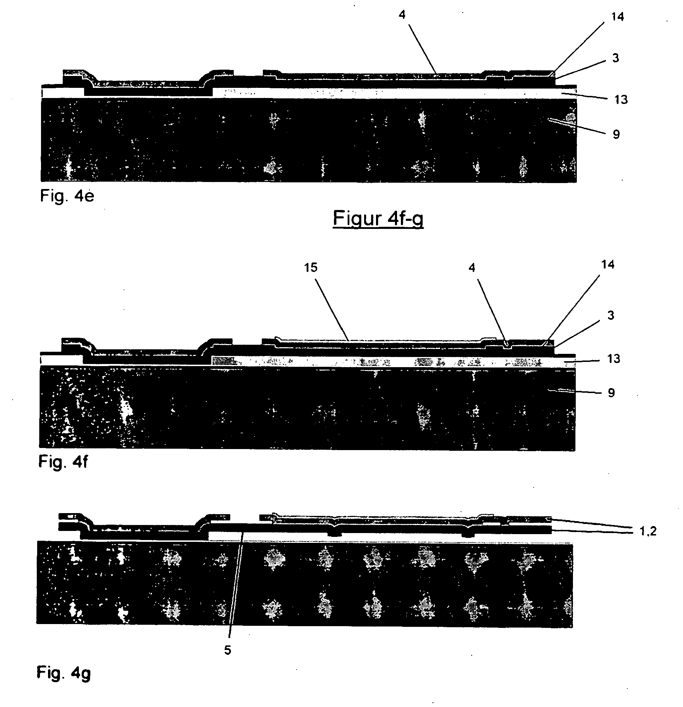

- Figur 4d: Auf die erste Materialschicht 3 wird eine zweite Opferschicht 14 aufgebracht. Diese wird ebenfalls mit einer Maskierung versehen und in der gewünschten Form geätzt. Dabei entspricht die auf der ersten Materialschicht 3 verbleibende zweite Opferschicht 14 in ihren geometrischen Formen 14a, 14b, und 14c, dem Aufnahmeschlitz 6, der Lücke 6a sowie der Unterbrechung der zweiten Materialschicht 4 am Steg 5 (vgl. Figur 4e). Ist ein größerer Querschnitt des Steges 5 gewünscht kann auch auf die Form 14c verzichtet werden.
- Figur 4e: Auf die zweite Opferschicht 14 wird die zweite Materialschicht 4 aus Polysilizium abgeschieden, maskiert und entsprechend geätzt. Wie in Figur 4e erkennbar ist, wird die zweite Materialschicht 4 am Steg 5 durch das Strukturieren der zweiten Materialschicht 4 unterbrochen. Dies ist der Fall, wenn ein zu großes Aspektverhältnis erwartet wird, d.h. die Höhe des Steges größer wird als die Breite des Steges. Bei einem gewünschten größeren Querschnitt des Steges 5 wird auf die Form 14 c verzichtet und die zweite Materialschicht direkt auf den Steg aufgebracht. In diesem Fall sollte die Breite des Steges jedoch nicht geringer als die Höhe der beiden Schichten sein.
- Figur 4f: Zur Stabilisierung wird auf die zweite Materialschicht 4 eine Metallschicht 15 abgeschieden. Die Metallschicht 15 wird ebenfalls entsprechend strukturiert. Diese abgeschiedene Metallschicht 15 kann auch als Startschicht für weitere galvanische Abscheidungen dienen. Anstelle einer Metallschicht 15 können hierfür auch andere Materialien, bspw. Kunststoffe oder Halbmetalle, genutzt werden.
- Figur 4 g: Der letzte Verfahrensschritt zur Herstellung des Mikrogreifers 8 besteht im Entfernen der ersten und zweiten Opferschicht 13, 14 durch eine Ätzlösung. Die Auswahl zum Entfernen der Opferschichten 13, 14 richtet sich natürlich nach dem Material aus dem die Opferschicht 13, 14 besteht.

Die nach dem Verfahren gemäß Figuren 4a-g hergestellten Mikrogreifer 8 können zum Aufnehmen und Halten von Objekten im Mikrometer- und SubmikrometerBereich eingesetzt werden. Eine spezielle Anwendung des Mikrogreifers ist die Aufnahme von elektronentransparenten Proben für deren anschließende Untersuchung in einem TEM oder SEM. Derartige Proben werden mittels der dem Fachmann bekannten, so genannten Focused Ion Beam -Technik (FIB-Technik) aus einem zu untersuchenden Material herauspräpariert.

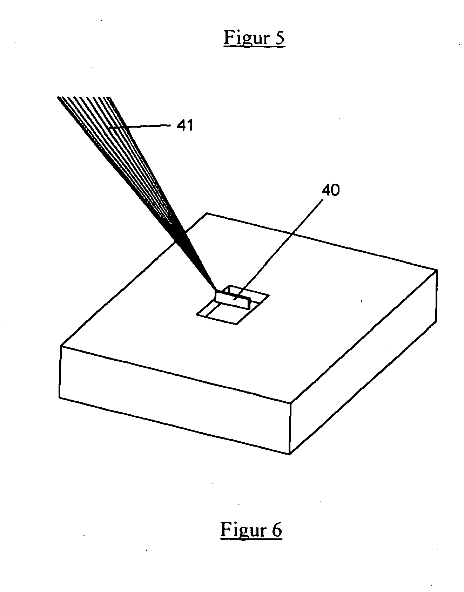

Die in Figur 5 dargestellte herkömmliche Methode zum Aufnehmen einer derartiger TEM-Probe 40 benutzt eine Nadel 41, die mittels Materialabscheidung an der TEM-Probe 40 befestigt wird. Die erfindungsgemäß hergestellte Mikrogreifer 8 ermöglicht hingegen, eine mittels FIB-Technik hergestellte elektronentransparente Probe 40 mit den Greifelementen 1, 2 in einer FIB-Präparationsanlage entsprechend den Figuren 2a und 2b aufzunehmen.

Die Figur 6 zeigt den Mikrogreifer 8 und die zwischen die Greifelemente 1, 2 geklemmte TEM-Probe 40. Die TEM-Probe 40 kann direkt in das TEM übernommen werden und steht sofort zur Untersuchung mit dem Elektronenstrahl 53 lagerichtig zur Verfügung. Der wesentliche Vorteil dieser Vorgehensweise besteht darin, dass der komplizierte bisher verwendete so genannten Lift-Out-Prozess durch das einmalige Greifen der TEM-Probe 40 durch den Mikrogreifer ersetzt wird. Nach dem Aufnehmen der TEM-Probe 40 kann diese samt Mikrogreifer im TEM untersucht werden. Falls erforderlich, ist nach dem Aufnehmen der TEM-Probe durch den Mikrogreifer eine Nachbearbeitung der TEM-Probe in der FIB-Präparationsanlage möglich.

Da die Breite des Aufnahmeschlitzes 6 des Mikrogreifers 8 nur innerhalb eines bestimmten Bereichs variiert werden kann, wird die TEM-Probe 40 mittels der FIB-Technik so dimensioniert, dass an der späteren Kontaktfläche zum Mikrogreifer 8, die zum Halten erforderliche Probendicke erreicht wird. Der übrige Bereich der TEM-Probe wird auf die für die TEM-Untersuchung notwendige Elektronentransparenz präpariert.

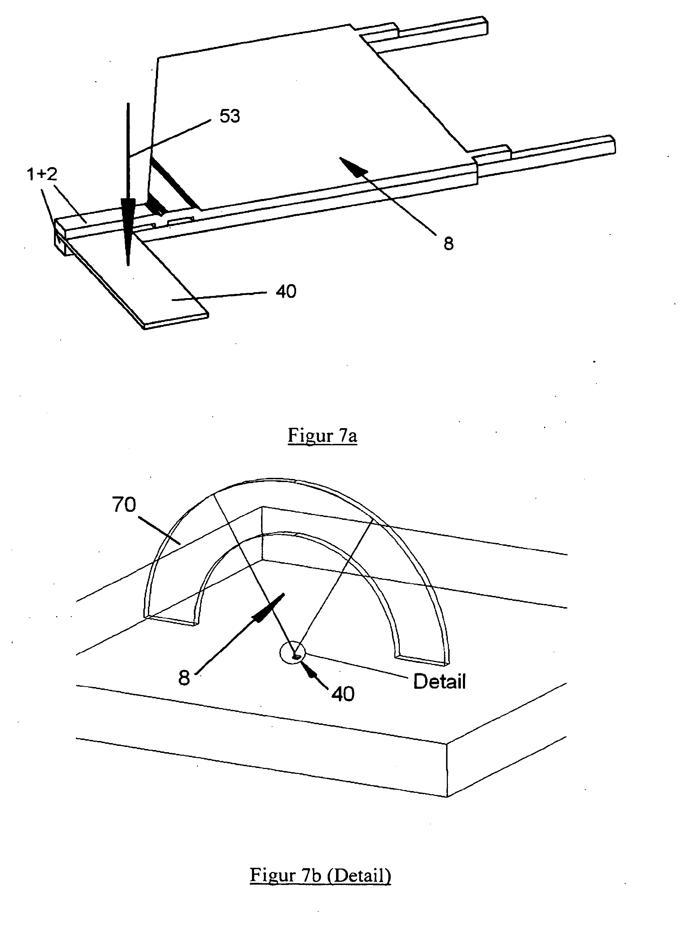

Die Figuren 7a und 7b zeigen eine weitere vorteilhafte Ausführungsform des erfindungsgemäßen Mikrogreifers 8. In diesem Beispiel wird der Mikrogreifer 8 in Verbindung mit einem Halbring 70, der einen Innenradius und einen Außenradius aufweist, verwendet. Der Mikrogreifer 8 besitzt einen flächigen Basiskörper in Form eines Kreissektors, wobei der Greifkörper mit der TEM-Probe 40 an der Kreissektorspitze den Kreissektor überragend angeordnet ist. Der Radius des Kreissektors der Basiskörperform ist größer als der Innenradius des Halbringes 70. Idealerweise ist der Außenradius des Halbrings 70 und der Radius des Kreissektors des Basiskörpers gleich. Der Mikrogreifer 8 wird mit Hilfe einer Vorrichtung, bspw. einer Vakuumpipette, aufgenommen und wie dargestellt mittels eines Adhäsivs auf dem Halbring 70 befestigt. Dieser Halbring 70 kann dabei aus unterschiedlichen Materialien, welche in der TEM-Analyse eingesetzt werden, bestehen. Die Greifelemente 1, 2 stehen dabei über den Halbring über, so dass diese Anordnung zum Aufnehmen von TEM-Proben 40 aus einem Substrat geeignet ist. Figur 7b zeigt in einer Detailvergrößerung das Aufnehmen einer solchen TEM-Probe 40 aus einem entsprechend vorbereiteten Substrat. Auf dem Halbring 70 können natürlich auch anders geformte Mikrogreifer befestigt werden. Die äußere Form des Basiskörpers muss daher nicht zwangsweise einem Kreisausschnitt ähnlich sein.

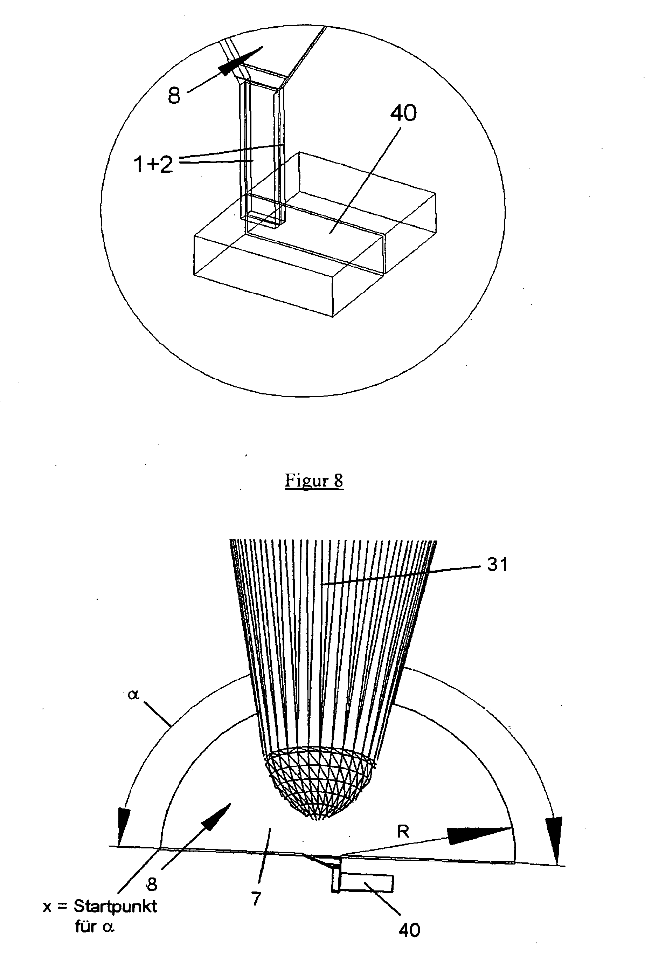

Figur 8 zeigt eine Ausführungsform des erfindungsgemäßen Mikrogreifers 8, bei der der Basiskörper mit einer halbkreisförmigen Flachkörperoberfläche 7 ausgebildet ist. Der Radius R dieses Halbkreises ist so bemessen, dass eine anschließende direkte Übernahme des Mikrogreifers 8 in die Probenhalterung des TEM erfolgen kann. Der Mikrogreifer 8 wird zunächst von einer Aufnahmevorrichtung 31 gehalten und damit die Aufnahme der TEM-Probe 40 durchgeführt. Diese Anordnung ermöglicht die direkte Übernahme des Mikrogreifers 8 in die Probenhalterung des TEM, ohne dass eine zusätzliche Adaption an einen halbkreisförmigen Ring vorzunehmen ist. Werden statt der Halbkreisform des Basiskörpers Kreissektoren mit Mittelpunktswinkeln < 180 Grad verwendet, gestaltet sich die Halterung der Mikrogreifer in der Probenhalterung des TE-Mikroskops schwierig, da der Mikrogreifer lateral verrutschen kann und somit nicht richtig von der Klemmmutter des Probenträgers gefasst wird.

### Bezugszeichenliste

- 1, 2: Greifelemente
- 3: Erste Materialschicht
- 4: Zweite Materialschicht
- 5: Steg
- 6, 6a: Aufnahmeschlitz, Lücke
- 7: Flachkörperoberfläche im Bereich des Basiskörpers
- 8: Mikrogreifer, Flachkörper
- 9: Substrat
- 10: Materialprobe
- 11: Schräge
- 12: Zwischenschicht
- 13: Erste Opferschicht
- 14, 14a-c: Zweite Opferschicht
- 15: Metallschicht, Stabilisierungsschicht
- 20: Haltebereich
- 31: Aufnahmevorrichtung
- 40: TEM-Probe
- 53: Elektronenstrahl
- 70: Halbring

## Patentansprüche

1. Verfahren zur Herstellung eines Mikrogreifers (8), der einen Basiskörper sowie einen mit dem Basiskörper einstückig verbundenen Greifkörper umfasst, der den Basiskörper überragt und an einem freien Endbereich einen Aufnahmeschlitz (6) derart vorsieht, dass zum Greifen und Halten ein Mikrometer- oder Submikrometer-skaliges Objekt in den Aufnahmeschlitz (6) klemmbar ist,
wobei der Basiskörper und der Greifkörper mittels eines Materialabscheideverfahrens unter Ausbildung wenigstens einer gemeinsamen ersten und einer gemeinsamen zweiten Materialschicht (3, 4) hergestellt werden, und die Materialschichten (3, 4) im wesentlichen eben ausgebildet und miteinander unter Durchführung der folgenden Verfahrensschritte verbunden werden:
- Bereitstellen einer ebenen Substratoberfläche,
- Aufbringen einer ersten Opferschicht (13) auf die Substratoberfläche,
- Aufbringen der ersten Materialschicht (3) auf die erste Opferschicht (13),
- Lokales Aufbringen einer zweiten Opferschicht (14) auf die erste Materialschicht (3), zumindest auf den dem Aufnahmeschlitz entsprechenden lokalen Bereich der ersten Materialschicht (3),
- Aufbringen der zweiten Materialschicht (4) auf die zweite Opferschicht (14) sowie die nicht überdeckten Bereiche der ersten Materialschicht (3),
- Entfernen der zweiten Opferschicht (14) zur Ausbildung des Aufnahmeschlitzes und
- Entfernen der ersten Opferschicht (13) zur vollständigen Ablösung des hergestellten Mikrogreifers von der Substratoberfläche.

2. Verfahren nach Anspruch 1,
**dadurch gekennzeichnet, dass** das Aufbringen der ersten Opferschicht (13) in wenigstens einem lokal begrenzten Flächenbereich auf der Substratoberfläche erfolgt , und/oder dass nach dem Aufbringen der ersten Opferschicht (13) auf der Substratoberfläche eine Strukturierung der ersten Opferschicht (13) durchgeführt wird.

3. Verfahren nach Anspruch 1 oder 2,
**dadurch gekennzeichnet, dass** das Aufbringen der ersten Materialschicht (3) auf der ersten Opferschicht (13) in wenigstens einem lokal begrenzten Flächenbereich auf der ersten Opferschicht (13) erfolgt, und/ oder dass nach dem Aufbringen der ersten Materialschicht (3) auf der ersten Opferschicht (13) eine Strukturierung der ersten Materialschicht (3) durchgeführt wird.

4. Verfahren nach einem der Ansprüche 1 bis 3,
**dadurch gekennzeichnet, dass** nach dem Aufbringen der zweiten Opferschicht (14) auf der ersten Materialschicht (3) eine Strukturierung der zweiten Opferschicht (14) erfolgt.

5. Verfahren nach einem der Ansprüche 1 bis 4,
**dadurch gekennzeichnet, dass** das Aufbringen der zweiten Materialschicht (4) auf der zweiten Opferschicht (14) sowie der ersten Materialschicht (3) in wenigstens einem lokal begrenzten Flächenbereich auf der zweiten Opferschicht (14) sowie der ersten Materialschicht (3) erfolgt und/oder dass nach dem Aufbringen der zweiten Materialschicht (4) auf der zweiten Opferschicht (14) sowie der ersten Materialschicht (3) eine Strukturierung der zweiten Materialschicht (4) erfolgt.

6. Verfahren nach einem der Ansprüche 1 bis 5,
**dadurch gekennzeichnet, dass** vor dem Aufbringen der ersten Opferschicht (13) auf der Substratoberfläche eine oder mehrere Zwischenschichten (12) auf der Substratoberfläche aufgebracht werden.

7. Verfahren nach einem der Ansprüche 1 bis 6,
**dadurch gekennzeichnet, dass** auf die zweite Materialschicht (4) eine oder mehrere Stabilisierungsschichten (15) aufgebracht werden.

8. Mikrogreifer hergestellt mit einem Verfahren nach einem der Ansprüche 1 bis 7, der einen Basiskörper sowie einen mit dem Basiskörper einstückig verbundenen Greifkörper umfasst, der den Basiskörper überragt und an einem freien Endbereich einen Aufnahmeschlitz (6) derart vorsieht, dass zum Greifen und Halten ein Mikrometer- oder Submikrometer-skaliges Objekt in den Aufnahmeschlitz (6) klemmbar ist, wobei der Basiskörper und der Greifkörper als ein einheitlicher Flachkörper (8) ausgebildet sind, der ausschließlich von zwei im wesentlichen ebenen, parallel zueinander orientierten und sich überlappenden Flachkörperoberflächen begrenzt ist und der im Wege eines Materialabscheideverfahrens herstellbar ist, bei dem wenigstens eine erste und eine zweite Materialschicht (3, 4) bereichsweise direkt miteinander verbunden werden.

9. Mikrogreifer nach Anspruch 8,
**dadurch gekennzeichnet, dass** sich die Flachkörperoberflächen vollständig überlappen.

10. Mikrogreifer nach Anspruch 8 oder 9
**dadurch gekennzeichnet, dass** die Flachkörperoberflächen einem Kreissektor mit einem Mittelpunktswinkel α ≤ 180 Grad entsprechen und der Greifkörper an einer Kreissektorspitze den Kreissektor überragend angeordnet ist.

11. Mikrogreifer nach Anspruch 8 oder 9,
**dadurch gekennzeichnet, dass** die Flachkörperoberflächen einem Kreissegment mit einem Mittelpunktswinkel α ≤ 180 Grad entsprechen und der Greifkörper an der Kreissegmentsehne, insbesondere in der Mitte der Kreissegmentsehne, das Kreissegment überstehend angeordnet ist.

12. Mikrogreifer nach Anspruch 8 oder 9,
**dadurch gekennzeichnet, dass** die Flachkörperoberflächen einem Vieleck entsprechen und der Greifkörper einen Umfangsrand des Vielecks überragend angeordnet ist.

13. Mikrogreifer nach einem der Ansprüche 10 oder 11,
**dadurch gekennzeichnet, dass** das Kreissegment oder der Kreissektor einen Kreisradius aufweist, der an einen Radius einer Probenhalterung eines Mikroskops, insbesondere eines SE- oder TE-Mikroskops, angepasst ist.

14. Mikrogreifer nach einem der Ansprüche 8 bis 13,
**dadurch gekennzeichnet, dass** der Aufnahmeschlitz (6) innenliegend zwei zueinander parallel angeordnete, voneinander beabstandete und sich überlappende Klemmflächen aufweist.

15. Verwendung des Mikrogreifers nach einem der Ansprüche 8 bis 14 zum Aufnehmen, Transportieren und Halten von Materialproben im Rahmen von deren Untersuchung in einem TE-Mikroskop.

## Claims

1. A method for producing a microgripper (8), which comprises a base body and a gripper body integrally connected to the base body, which protrudes beyond the base body and provides a receiving slot (6) on a free end area such that a micrometer-scale or submicrometer-scale object can be clamped in the receiving slot (6) for gripping and holding,
the base body and the gripper body being implemented using a material deposition method while implementing at least one shared first material layer and one shared second material layer (3, 4), and the material layers (3, 4) are implemented as essentially level and are bonded to one another while performing the following method steps:
- providing a level substrate surface,
- applying a first sacrificial layer (13) to the substrate surface,
- applying the first material layer (3) to the first sacrificial layer (13),
- locally applying a second sacrificial layer (14) to the first material layer (3), at least on the local area of the first material layer (3) corresponding to the receiving slot,
- applying the second material layer (4) to the second sacrificial layer (14) and the uncovered areas of the first material layer (3),
- removing the second sacrificial layer (14) to implement the receiving slot, and
- removing the first sacrificial layer (13) to completely detach the produced microgripper from the substrate surface.

2. The method according to Claim 1,
**characterized in that** the application of the first sacrificial layer (13) is performed in at least one locally delimited surface area on the substrate surface, and/or after the application of the first sacrificial layer (13) on the substrate surface, a structuring of the first sacrificial layer (13) is performed.

3. The method according to Claim 1 or 2,
**characterized in that** the application of the first material layer (3) on the first sacrificial layer (13) is performed in at least one locally delimited surface area on the first sacrificial layer (13), and/or, after the application of the first material layer (3) on the first sacrificial layer (13), a structuring of the first material layer (3) is performed.

4. The method according to one of Claims 1 through 3,
**characterized in that,** after the application of the second sacrificial layer (14) on the first material layer (3), a structuring of the second sacrificial layer (14) is performed.

5. The method according to one of Claims 1 through 4,
**characterized in that** the application of the second material layer (4) on the first sacrificial layer (14) and the first material layer (3) is performed in at least one locally delimited surface area on the second sacrificial layer (14) and the first material layer (3), and/or, after the application of the second material layer (4) on the second sacrificial layer (14) and the first material layer (3), a structuring of the second material layer (4) is performed.

6. The method according to one of Claims 1 through 5,
**characterized in that,** before the application of the first sacrificial layer (13) on the substrate surface, one or more intermediate layers (12) are applied on the substrate surface.

7. The method according to one of Claims 1 through 6,
**characterized in that** one or more stabilization layers (15) are applied on the second material layer (4).

8. A microgripper produced using a method according to one of Claims 1 through 7, which comprises a base body and a gripper body which is integrally connected to the base body, which protrudes beyond the base body and provides a receiving slot (6) on a free end area such that a micrometer-scale or submicrometer-scale object can be clamped in the receiving slot (6) for gripping and holding, the base body and the gripper body being implemented as a uniform planar body (8), which is exclusively delimited by two essentially level planar body surfaces, which are oriented parallel to one another and overlap, and is producible in the course of a material deposition method, in which at least a first material layer and a second material layer (3, 4) are regionally directly bonded to one another.

9. The microgripper according to Claim 8,
**characterized in that** the planar body surfaces completely overlap.

10. The microgripper according to Claim 8 or 9,
**characterized in that** the planar body surfaces correspond to a circular sector having a center point angle α ≤ 180° and the gripper body is situated protruding beyond on a circular sector tip of the circular sector.

11. The microgripper according to Claim 8 or 9,
**characterized in that** the planar body surfaces correspond to a circular segment having a center point angle α ≤ 180° and the gripper body is situated on the circular segment chord, in particular in the center of the circular segment chord, protruding beyond the circular segment.

12. The microgripper according to Claim 8 or 9,
**characterized in that** the planar body surfaces correspond to a polygon and the gripper body is situated protruding beyond a peripheral edge of the polygon.

13. The microgripper according to one of Claims 10 or 11,
**characterized in that** the circular segment or the circular sector has a circular radius which is adapted to a radius of a sample holder of a microscope, in particular a SE or TE microscope.

14. The microgripper according to one of Claims 8 through 13,
**characterized in that** the receiving slot (6) has two internal clamping faces, which are situated parallel to one another, spaced apart from one another, and overlapping.

15. A use of the microgripper according to one of Claims 8 through 14 for receiving, transporting, and holding material samples in the context of the study thereof in a TE microscope.

## Revendications

1. Procédé de fabrication d'une micro-griffe (8), comprenant un corps de base, ainsi qu'un corps de préhension relié en monobloc avec le corps de base qui saillit par-dessus le corps de base et qui sur une zone d'extrémité libre prévoit une encoche de réception (6) de telle sorte que pour la préhension et le maintien, un objet de dimensions de l'ordre des micromètres ou des sous-micromètres soit susceptible d'être serré dans l'encoche de réception (6),
le corps de base et le corps de préhension étant fabriqués au moyen d'un procédé de séparation de matières, en formant au moins une première couche de matière commune et une deuxième couche de matière commune (3, 4) et en ce que les couches de matières (3, 4) sont sensiblement réalisées de manière plane et sont reliées les unes aux autres par réalisation des étapes de procédé suivantes :
- mise à disposition d'une surface de substrat plane
- application d'une première couche sacrificielle (13) sur la surface du substrat,
- application de la première couche de matière (3) sur la première couche sacrificielle (13),
- application locale d'une deuxième couche sacrificielle (14) sur la première couche de matière (3), au moins sur la zone locale correspondant à l'encoche de réception de la première couche de matière (3),
- application de la deuxième couche de matière (4) sur la deuxième couche sacrificielle (14), ainsi que sur les zones non recouvertes de la première couche de matière (3),
- retrait de la deuxième couche sacrificielle (14) pour créer l'encoche de réception et
- retrait de la première couche sacrificielle (13) pour détacher complètement la micro-griffe fabriquée de la surface du substrat.

2. Procédé selon la revendication 1,
**caractérisé en ce que** l'application de la première couche sacrificielle (13) s'effectue dans au moins une zone de surface localement limitée sur la surface du substrat, et/ou **en ce qu'**après l'application de la première couche sacrificielle (13) sur la surface du substrat, il est procédé à une structuration de la première couche sacrificielle (13).

3. Procédé selon la revendication 1 ou 2,
**caractérisé en ce que** l'application de la première couche de matière (3) sur la première couche sacrificielle (13) s'effectue sur au moins une zone de surface localement limitée sur la première couche sacrificielle (13) et/ou **en ce qu'**après l'application de la première couche de matière (3) sur la première couche sacrificielle (13), il est procédé à une structuration de la première couche de matière (3).

4. Procédé selon l'une quelconque des revendications 1 à 3,
**caractérisé en ce qu'**après l'application de la deuxième couche sacrificielle (14) sur la première couche de matière (3), il est procédé à une structuration de la deuxième couche de matière (14).

5. Procédé selon l'une quelconque des revendications 1 à 4,
**caractérisé en ce que** l'application de la deuxième couche de matière (4) sur la deuxième couche sacrificielle (14), ainsi que de la première couche de matière (3) s'effectue dans au moins une zone de surface limitée localement sur la première couche sacrificielle (14) ainsi que de la première couche de matière (3) et/ou **en ce qu'**après l'application de la deuxième couche de matière (4) sur la deuxième couche sacrificielle (14) ainsi que de la première couche de matière (3), il est effectué une structuration de la deuxième couche de matière (4).

6. Procédé selon l'une quelconque des revendications 1 à 5,
**caractérisé en ce qu'**avant l'application de la première couche sacrificielle (13) sur la surface du substrat, on applique une ou plusieurs couches intermédiaires (12) sur la surface du substrat.

7. Procédé selon l'une quelconque des revendications 1 à 6,
**caractérisé en ce que** sur la deuxième couche de matière (4) on applique une ou plusieurs couches de stabilisation (15).

8. Micro-griffe fabriquée à l'aide d'un procédé selon l'une quelconque des revendications 1 à 7, comprenant un corps de base, ainsi qu'un corps de préhension relié en monobloc avec le corps de base, qui saillit par dessus le corps de base et qui sur une zone d'extrémité libre prévoit une encoche de réception (6), de telle sorte que pour la préhension et le maintien, un objet de dimensions de l'ordre des micromètres ou des sous-micromètres soit susceptible d'être serré dans l'encoche de réception (6),
le corps de base et le corps de préhension étant conçus comme un corps plat homogène (8) qui est exclusivement limité par deux surfaces de corps plat sensiblement planes, orientées à la parallèle l'une de l'autre et se chevauchant et qui est susceptible d'être fabriquée en utilisant un procédé de séparation de matière, dans lequel on relie directement l'une à l'autre par zones au moins une première et une deuxième couche de matière (3, 4).

9. Micro-griffe selon la revendication 8,
**caractérisée en ce que** les surfaces de corps plats se chevauchent entièrement.

10. Micro-griffe selon la revendication 8 ou 9
**caractérisée en ce que** les surfaces de corps plats correspondent à un secteur de cercle avec un angle du centre α ≤ à 180 degrés et **en ce que** le corps de préhension est disposé sur une pointe du secteur de cercle, en saillissant par-dessus le secteur de cercle.

11. Micro-griffe selon l'une quelconque des revendications 8 ou 9,
**caractérisée en ce que** les surfaces de corps plats correspondent à un segment de cercle avec un angle du centre α ≤ à 180 degrés et **en ce que** le corps de préhension est disposé sur la corde du segment de cercle, notamment au centre de la corde du segment de cercle, en débordant par-dessus le segment de cercle.

12. Micro-griffe selon la revendication 8 ou 9,
**caractérisée en ce que** les surfaces de corps plats correspondent à un polygone et **en ce que** le corps de préhension est disposé≤ à 180 degrés en saillissant par-dessus un bord périphérique du polygone.

13. Micro-griffe selon l'une quelconque des revendications 10 ou 11,
**caractérisée en ce que** le segment de cercle ou le secteur de cercle comporte un rayon de courbure qui est adapté à un rayon d'une fixation d'essai d'un microscope, notamment d'un microscope SE ou TE.

14. Micro-griffe selon l'une quelconque des revendications 8 à 13,
**caractérisée en ce que** l'encoche de réception (6) comporte à l'intérieur deux surfaces de serrage disposées en parallèle l'une de l'autre, écartées l'une de l'autre et se chevauchant.

15. Utilisation de la micro-griffe selon l'une quelconque des revendications 8 à 14 pour prendre, transporter et maintenir des échantillons de matières dans le cadre de leur analyse dans un microscope TE.
